(19) Europäisches Patentamt
European Patent Office
Office européen des brevets

(11) **EP 4 053 962 A1**

(12) **EUROPEAN PATENT APPLICATION**
published in accordance with Art. 153(4) EPC

(43) Date of publication:
**07.09.2022 Bulletin 2022/36**

(21) Application number: **21744697.0**

(22) Date of filing: **05.01.2021**

(51) International Patent Classification (IPC):
*H01M 10/42* (2006.01)   *H01M 10/48* (2006.01)
*H02J 7/00* (2006.01)   *G01R 31/367* (2019.01)
*G01R 31/389* (2019.01)   *G01R 31/392* (2019.01)

(52) Cooperative Patent Classification (CPC):
**G01R 31/367; G01R 31/389; G01R 31/392;
H01M 10/42; H01M 10/48; H02J 7/00;** Y02E 60/10

(86) International application number:
**PCT/JP2021/000133**

(87) International publication number:
**WO 2021/149483 (29.07.2021 Gazette 2021/30)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **20.01.2020 JP 2020007037**

(71) Applicant: **Toyo System Co., Ltd.
Iwaki-shi, Fukushima 972-8316 (JP)**

(72) Inventors:
• **MUNAKATA, Ichiro
Iwaki-shi, Fukushima 972-8316 (JP)**
• **SHOJI, Hideki
Iwaki-shi, Fukushima 972-8316 (JP)**

(74) Representative: **Schön, Christoph
Dr. Schön, Neymeyr & Partner mbB
Bavariaring 26
80336 München (DE)**

(54) **SIMULATED BATTERY CONTROL DEVICE, ELECTRONIC APPARATUS, CHARGER, AND SIMULATED BATTERY CONTROL METHOD**

(57)    There is provided a device or the like capable of improving the convenience of reproduction under various conditions of the characteristics of a secondary battery by using a simulated battery. Based on the communication between the electronic apparatus 200 and/or the charger 400 coupled to the electronic apparatus 200, and the simulated battery control device, the operation of the simulated battery 230 mounted on the electronic apparatus 200 is controlled, and the voltage corresponding to the current command value is applied to the specified load 250. Then, the operating characteristic information corresponding to the operating characteristic of the specified load 250 corresponding to the applied voltage is output to the output interface 204 of the electronic apparatus 200. Therefore, the user does not need to bring the electronic apparatus 200 to a specialized institution or the like, and the operating characteristics of the specified load 250 can be grasped when voltage corresponding to the current command value is applied to the specified load 250 of the electronic apparatus 200, and therefore the convenience of the user of the electronic apparatus 200 can be improved.

FIG.1

EP 4 053 962 A1

**Description**

Technical Field

The present invention relates to a technique for simulating the performance of a secondary battery such as a lithium-ion battery.

Background Art

The internal resistance of a secondary battery is coupled to the parallel circuit of a resistor R and a capacitor C in multiple stages to form an equivalent circuit, and the change in the behavior waveform of current-voltage is discussed. However, in order to describe the transient response waveform of a voltage of several seconds or more, a capacitor capacitance value as a time constant element ranges from a few hundred F to a few thousand F. This value is a numerical value that cannot correspond to AC impedance and the equivalent circuit model thereof, which is a method for evaluating the AC characteristics of a battery, and it cannot be said that the properties of the battery are reproduced.

Internal resistance is a characteristic of a secondary battery. For example, in a lithium-ion secondary battery (hereinafter, referred to as a LIB secondary battery), because complicated chemical reactions such as an electrode reaction, an SEI reaction, and an ion diffusion reaction are intertwined inside the battery, the behavior of a battery voltage is not the same as that of Ohm's law, considering internal resistance as a simple DC resistance.

As a method of strengthening the internal resistance of a battery, previously, AC impedance analysis based on frequency response analysis (FRA) has been well known, and a method has been established to analyze and interpret various internal reactions into several time constant elements by using equivalent circuit models. The diffusion phenomenon as the Warburg resistance occupies the dominant influence on the behavior on the order of seconds of a battery, and how the Warburg resistance can be incorporated as an operation model determines the performance as a model. A dedicated device such as a frequency response analyzer (FRA) is required to perform AC impedance measurement.

Citation List

Patent Literature

Patent Document 1: Japanese Patent No. 5924617

Summary of Invention

Technical Problem

However, in practical use, a secondary battery is coupled to a load, and charging and discharging are repeated. In that case, only voltage, current, and temperature are the basic information for knowing the state of the secondary battery. Under such circumstances, the output voltage of the battery is affected by the internal resistance, and the internal resistance itself also changes depending on the temperature conditions or the degree of deterioration of the battery, and a means for accurately reproducing the characteristics of the battery in an actual operating state is needed.

Therefore, an object of the present invention is to provide a device or the like capable of improving the convenience of reproduction under various conditions of the characteristics of a secondary battery by using a simulated battery.

Solution to Problem

A simulated battery control device according to the present invention includes a first control element configured to identify a value of a parameter of a secondary battery model representing current dependence of an output voltage of a secondary battery mounted or to be mounted on an electronic apparatus as a power supply, based on communication with the electronic apparatus, a second control element configured to recognize a time series of command current values based on the communication with the electronic apparatus and to calculate a model output voltage as a change mode of a voltage output from the secondary battery model when the time series of the command current values is input to the secondary battery model of which the value of the parameter is recognized by the first control element, and a third control element configured to apply the model output voltage calculated by the second control element to a simulated battery mounted on the electronic apparatus or a power supply device for a specified load of the electronic apparatus, based on communication with the electronic apparatus or the power supply device as a charging power supply of the secondary battery.

A simulated battery control method according to the present invention includes a first control step of identifying a value of a parameter of a secondary battery model representing current dependence of an output voltage of a secondary battery mounted or to be mounted on an electronic apparatus as a power supply, based on communication with the electronic apparatus, a second control step of recognizing a time series of command current values based on the communication with the electronic apparatus and calculating a model output voltage as a change mode of a voltage output from the secondary battery model when the time series of the command current values is input to the secondary battery model of which the value of the parameter is recognized in the first control step, and a third control step of applying the model output voltage calculated in the second control step to a simulated battery mounted on the electronic apparatus or a power supply device for a specified load of the electronic apparatus, based on the communication with the electronic apparatus or the power supply device as a charging power supply of the secondary battery.

An electronic apparatus according to the present invention is an electronic apparatus on which a secondary battery is mounted as a power supply, including a simulated battery, a specified load, a first apparatus control element configured to cause a first control element constituting a simulated battery control device to identify a value of a parameter of a secondary battery model representing current dependence of an output voltage of the secondary battery based on communication with the simulated battery control device, a second apparatus control element configured to cause a second control element constituting the simulated battery control device to recognize a time series of command current values based on the communication with the simulated battery control device and to calculate a model output voltage as a change mode of a voltage output from the secondary battery model when the time series of the command current values is input to the secondary battery model of which the value of the parameter is recognized by the first control element, and a third apparatus control element configured to apply the model output voltage calculated by the second control element to the specified load from the simulated battery based on the communication with the simulated battery control device.

In the electronic apparatus of the present invention, it is preferable that the first apparatus control element causes the first control element to recognize a deterioration degree of the secondary battery based on the communication with the simulated battery control device, and identify a value corresponding to a difference in the deterioration degree as the value of the parameter of the secondary battery model.

In the electronic apparatus of the present invention, it is preferable that the first apparatus control element measures a temperature of the electronic apparatus or the simulated battery by using a temperature sensor, and causes the first control element to recognize a measurement result of the temperature of the electronic apparatus or the simulated battery based on the communication with simulated battery control device and identify a value corresponding to a difference in the measurement result of the temperature as the value of the parameter of the secondary battery model.

In the electronic apparatus of the present invention, it is preferable that the first apparatus control element causes the first control element to identify the value of the parameter of the secondary battery model, and the second apparatus control element causes the second control element to calculate the model output voltage provided that a first specified operation is performed through an input interface of the electronic apparatus.

In the electronic apparatus of the present invention, it is preferable that the first apparatus control element causes the first control element to identify the value of the parameter of the secondary battery model, and that the second apparatus control element causes the second control element to calculate the model output voltage provided that a power cut-off operation is performed through the input interface in the electronic apparatus as the first specified operation.

In the electronic apparatus of the present invention, it is preferable that the first apparatus control element causes the first control element to identify the value of the parameter of the secondary battery model, and that the second apparatus control element causes the second control element to calculate the model output voltage provided that the electronic apparatus is coupled to the charger.

In the electronic apparatus of the present invention, it is preferable that the third apparatus control element outputs information about operating characteristics of the specified load, when the model output voltage calculated by the second control element is applied to the simulated battery for the specified load of the electronic apparatus, to an output interface of the electronic apparatus.

In the electronic apparatus of the present invention, it is preferable that the third apparatus control element outputs the information about the operating characteristics of the specified load to the output interface based on the communication with the simulated battery control device provided that a second specified operation is performed through an input interface of the electronic apparatus.

In the electronic apparatus of the present invention, it is preferable that the third apparatus control element outputs the information about the operating characteristics of the specified load to the output interface based on the communication with the simulated battery control device provided that a wake operation of a sleep state of the output interface is performed through the input interface of the electronic apparatus as the second specified operation.

In the electronic apparatus of the present invention, it is preferable that the simulated battery is configured to be mounted as a replacement battery of the secondary battery.

A charger according to the present invention is a charger that is coupled to an electronic apparatus on which a secondary battery is mounted as a power supply, including a simulated battery, a first charger control element configured to cause a first control element constituting a simulated battery control device to identify a value of a parameter of a secondary battery model representing current dependence of an output voltage of the secondary battery based on communication with the simulated battery control device, a second charger control element configured to cause a second control element constituting the simulated battery control device to recognize a time series of command current values based on the communication with the simulated battery control device to calculate a model output voltage as a change mode of a voltage output from the secondary battery model when the time series of the command current values is input to the secondary battery model of which the value of the parameter is recognized by the first control element, and a third charger control element configured to apply the model output voltage calculated by the second control element to a specified load of the electronic apparatus from the simulated battery based on the communication with the simulated battery control device.

In the charger of the present invention, it is preferable that the first charger control element causes the first control element to recognize a deterioration degree of the secondary battery based on the communication with the simulated battery control device, and identify a value corresponding to a difference in the deterioration degree as the value of the parameter of the secondary battery model.

In the charger device of the present invention, it is preferable that the first charger control element measures a temperature of the electronic apparatus or the simulated battery by using a temperature sensor, and causes the first control element to recognize a measurement result of the temperature of the electronic apparatus or the simulated battery based on the communication with the simulated battery control device and identify a value corresponding to a difference in the measurement result of the temperature as the value of the parameter of the secondary battery model.

In the charger of the present invention, it is preferable that the first charger control element causes the first control element to identify the value of the parameter of the secondary battery model, and the second charger control element causes the second control element to calculate the model output voltage provided that a first specified operation is performed through an input interface of the electronic apparatus.

In the charger of the present invention, it is preferable that the first charger control element causes the first control element to identify the value of the parameter of the secondary battery model, and that the second charger control element causes the second control element to calculate the model output voltage provided that a power cut-off operation is performed through the input interface in the electronic apparatus as the first specified operation.

In the charger of the present invention, it is preferable that the first charger control element causes the first control element to identify the value of the parameter of the secondary battery model, and that the second charger control element causes the second control element to calculate the model output voltage provided that the electronic apparatus is coupled to the charger.

In the charger of the present invention, it is preferable that the third charger control element outputs information about operating characteristics of the specified load, when the model output voltage calculated by the second control element is applied to the simulated battery for the specified load of the electronic apparatus, to an output interface of the electronic apparatus.

In the charger of the present invention, it is preferable that the third charger control element outputs the information about the operating characteristics of the specified load to the output interface based on the communication with the simulated battery control device provided that a second specified operation is performed through the input interface of the electronic apparatus.

In the charger of the present invention, it is preferable that the third charger control element outputs the information about the operating characteristics of the specified load to the output interface based on the communication with the simulated battery control device provided that a wake operation of a sleep state of the output interface is performed through the input interface of the electronic apparatus as the second specified operation.

In the charger of the present invention, it is preferable that the simulated battery is configured to be detachably mounted and configured to be mountable in electronic apparatus as a substitute battery for secondary batteries.

Brief Description of Drawings

FIG. 1 is an explanatory diagram illustrating a configuration of a simulated battery control system as a first embodiment of the present invention.
FIG. 2 is an explanatory diagram illustrating an example of a configuration of a simulated battery.
FIG. 3 is a flowchart illustrating a first procedure of a simulated battery control method.
FIG. 4 is a flowchart illustrating a second procedure of the simulated battery control method.
FIG. 5 is an explanatory diagram regarding a calculation result of a voltage command value from a current command value.

FIG. 6 is a flowchart illustrating a procedure for establishing a secondary battery model.

FIG. 7 is an explanatory diagram regarding a Nyquist plot of a secondary battery.

FIG. 8 is an explanatory diagram regarding an AC impedance method.

FIG. 9A is a first exemplary explanatory diagram of an equivalent circuit of an internal resistance of the secondary battery.

FIG. 9B is a second exemplary explanatory diagram of an equivalent circuit of the internal resistance of the secondary battery.

FIG. 10A is a diagram representing a transfer function of an IIR system.

FIG. 10B is a diagram representing a transfer function of an FIR system.

FIG. 11 is an explanatory diagram illustrating a configuration of a simulated battery control system as a second embodiment of the present invention.

FIG. 12Ais an explanatory diagram regarding an impulse current.

FIG. 12B is an explanatory diagram illustrating voltage response characteristics of the secondary battery and the secondary battery model.

Description of Embodiments

(First Embodiment)

(Configuration of Simulated Battery Control System)

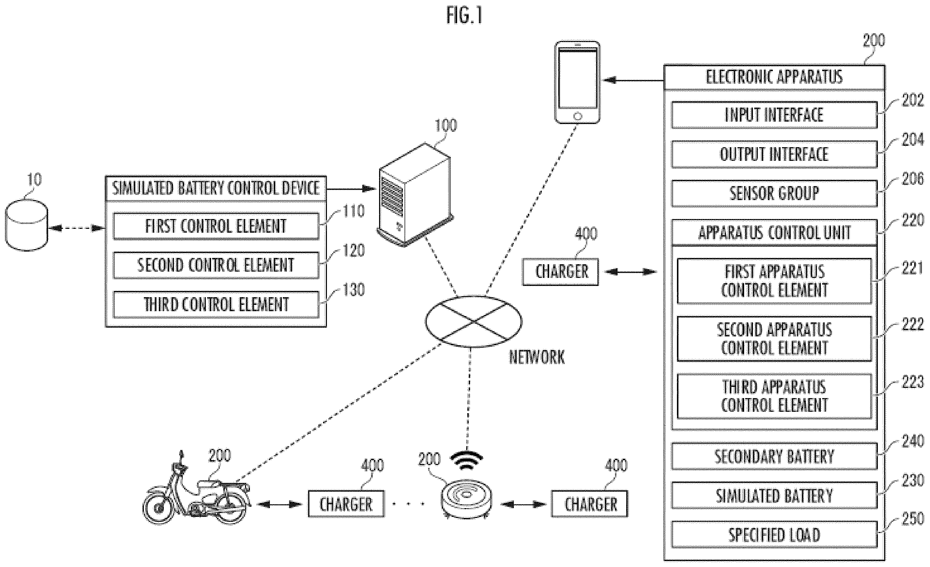

A simulated battery control system as a first embodiment of the present invention illustrated in FIG. 1 includes a simulated battery control device 100 and an electronic apparatus 200 capable of communicating via a network to each other. The simulated battery control device 100 includes one or a plurality of servers that can access a database 10. The simulated battery control device 100 evaluates the performance of a secondary battery 240 mounted as a power supply in the electronic apparatus 200.

The simulated battery control device 100 includes a first control element 110, a second control element 120, and a third control element 130. Each of the first control element 110, the second control element 120, and the third control element 130 include a processor (arithmetic processing unit), a memory (storage device), an I/O circuit, and the like.

A memory or a storage device separate from the memory stores and holds various data such as a measurement result of the voltage response characteristics of the secondary battery 240 with respect to a current (for example, an impulse current), as well as a program or software. For example, each of a plurality of identifiers for identifying the type (specified by the standard and specifications) of the secondary battery 240 or the electronic apparatus 200 on which the secondary battery 240 is mounted, and each of a plurality of secondary battery models are stored and held in a memory in association with each other. The processor reads the necessary programs and data from the memory, and based on the data, executes arithmetic processing according to the program, so that the arithmetic processing or task described later assigned to each of the elements 110, 120, and 130 can be executed.

The electronic apparatus 200 includes an input interface 202, an output interface 204, a sensor group 206, an apparatus control unit 220, a simulated battery 230, the secondary battery 240, and a specified load 250. Any apparatus powered by the secondary battery 240, such as a personal computer, a mobile phone (smartphone), a home appliance, or a moving object such as an electric bicycle, falls under the electronic apparatus 200. The secondary battery 240 is charged when the electronic apparatus 200 is coupled to a charger 400 via a coupling terminal or is wirelessly coupled.

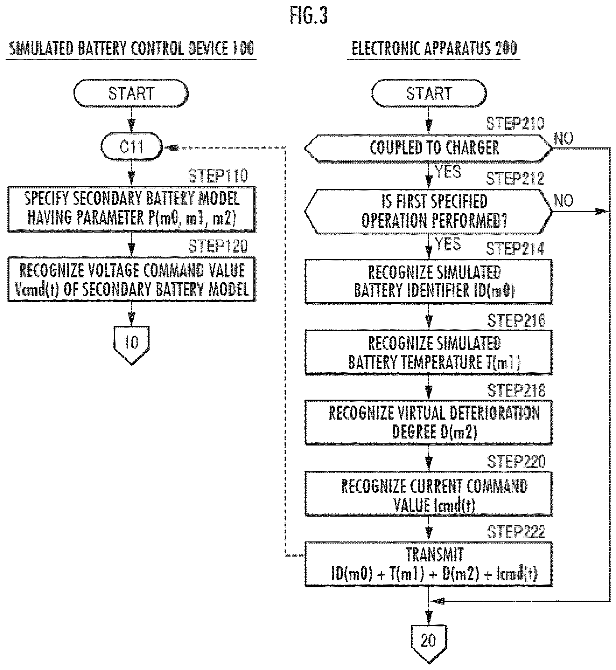

The apparatus control unit 220 includes a first apparatus control element 221, a second apparatus control element 222, and a third apparatus control element 223. Each of the first apparatus control element 221 and the second apparatus control element 222 and the third apparatus control element 223 includes a processor (arithmetic processing unit), a memory (storage device), an I/O circuit, and the like. A memory or a storage device separate from the memory stores and holds various data such as a simulated battery identifier ID(m0), a simulated battery temperature T(m1), and a virtual deterioration degree D(m2) (see FIG. 3/STEPS 214, 216, 218, and 220). The apparatus control unit 220 operates according to the power supplied from the secondary battery 240, and controls the operation of the electronic apparatus 200 in the energized state.

"Recognizing" information by each element means performing all kinds of arithmetic processing to prepare necessary information, such as receiving information, retrieving or reading information from information sources such as the database 10, and calculating and estimating information based on other information.

The operation of the electronic apparatus 200 includes the operation of an actuator (motorized actuator or the like) as the specified load 250 constituting the electronic apparatus 200. The processor constituting the apparatus control unit 220 reads necessary programs and data from the memory, and based on the data, executes the arithmetic processing assigned according to the program.

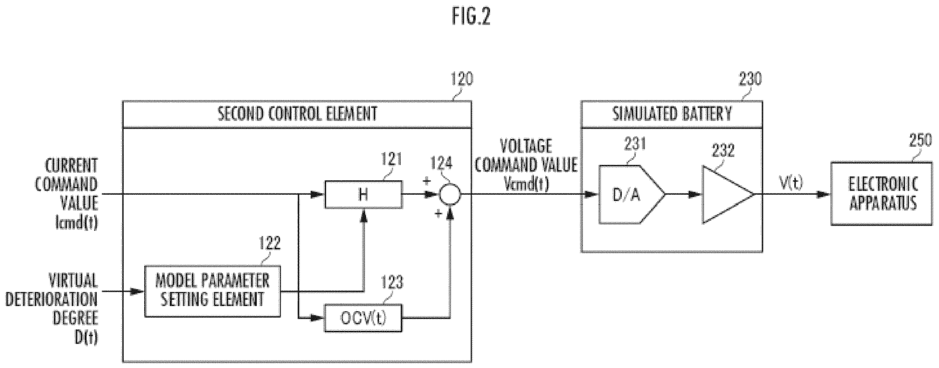

As illustrated in FIG. 2, the simulated battery 230 includes a D/A converter 231 and an amplifier 232. When a voltage command value Vcmd(t) output from a secondary battery model is input, the D/A converter 231 performs D/A conversion. The amplifier 232 applies a voltage V(t) corresponding to the output from the D/A converter 231 to the electronic apparatus 200 or the load constituting the electronic apparatus 200. "(t)" means a value or a time series at time t.

The calculator (second control element 120) equivalent to the secondary battery model includes a calculator 121, a model parameter setting element 122, an output device 123, and an adder 124. When a current command value Icmd(t) is input, the calculator 121 calculates the output voltage derived from the virtual internal resistance of the simulated battery 230. The value of the parameter defining a transfer function H of the calculator 121 is set or changed by the model parameter setting element 122 based on a deterioration degree D(n2) of the virtual secondary battery simulated by the simulated battery 230. The output device 123 outputs a virtual open circuit voltage OCV(t) of the simulated battery 230. The adder 124 adds the outputs of the calculator 121 and the output device 123, respectively.

The simulated battery 230 may be configured by an external power supply such as a commercial power supply to which the electronic apparatus 200 is coupled. The simulated battery 230 may be mounted on the electronic apparatus 200 instead of the secondary battery 240. The simulated battery 230 may include a second calculation element 122. In this case, the second calculation element 122 may be configured by a control device 210 constituting the electronic apparatus 200.

The secondary battery 240 is, for example, a lithium-ion battery, and may be another secondary battery such as a nickel hydrogen battery or a nickel cadmium battery. The sensor group 206 measures the voltage response characteristics and temperature of the secondary battery 240, as well as the values of parameters necessary for controlling the electronic apparatus 200. The sensor group 206 includes, for example, a voltage sensor, a current sensor, and a temperature sensor that output signals corresponding to the voltage, current, and temperature of the secondary battery 240.

The simulated battery control device 100 may be mounted on the electronic apparatus 200. In this case, a software server (not illustrated) may provide the function as the simulated battery control device 100 to an arithmetic processing unit by transmitting deterioration determination software to the arithmetic processing unit constituting the apparatus control unit 220 in the electronic apparatus 200.

(Simulated Battery Control Method)

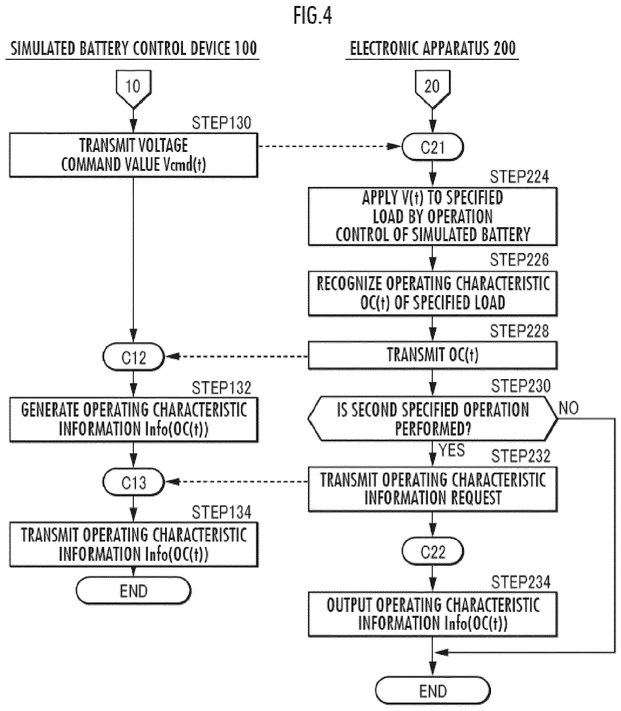

The operation control method or the construction method of the simulated battery 230 executed by the simulated battery control system of the first embodiment of the above configuration will be described with reference to the flowcharts illustrated in FIGS. 3 and 4. In the flowchart, the block "C●" is used for simplification, and refers to the transmission and/or reception of data and refers to a conditional branch that performs branch-direction processing on the condition that the data is transmitted and/or received.

In the electronic apparatus 200, the first apparatus control element 221 determines whether or not the electronic apparatus 200 is coupled to the charger 400 (FIG. 3/STEP 210). If the determination result is negative (FIG. 3/STEP 210: NO), it is determined whether or not the electronic apparatus 200 is coupled to the charger 400 again after a series of processing is completed.

On the other hand, when the determination result is positive (FIG. 3/STEP 210: YES), the first apparatus control element 221 further determines whether or not a first specified operation is performed through the input interface 202(FIG. 3/STEP 212). For example, an operation for switching the power of the electronic apparatus 200 from ON to OFF, an operation for switching the power of the electronic apparatus 200 from OFF to ON, an operation for stopping the operation of a predetermined application or the specified load 250 so that the arithmetic processing load such as CPU utilization and the like can be reduced to equal to or lower than a threshold, or an operation for starting a predetermined application or the specified load 250 corresponds to the "first specified operation".

If the determination result is negative (FIG. 3/STEP 212: NO), a series of processing is completed, and the processing after the determination processing of whether or not the electronic apparatus 200 is coupled to the charger 400 (FIG. 3/STEP 210) is executed.

On the other hand, when it is determined that the first specified operation has been performed (FIG. 3/STEP 212: YES), the first apparatus control element 221 recognizes the battery identifier ID(m0) for identifying the type of the virtual secondary battery (or secondary battery 240) simulated by the simulated battery 230 (FIG. 3/STEP 214). The battery identifier ID(m0) may be recognized by the first apparatus control element 221 according to the type of the virtual secondary battery set through the input interface 202 of the electronic apparatus 200.

The first apparatus control element 221 recognizes a temperature T(m1) of the virtual secondary battery simulated by the simulated battery 230 (FIG. 3/STEP 216). For example, the first apparatus control element 221 may recognize the temperature of the electronic apparatus 200 measured by the temperature sensor constituting the sensor group 206 of the electronic apparatus 200 as the temperature T(m1) of the virtual secondary battery. Further, the first apparatus control element 221 may recognize the temperature set through the input interface 202 of the electronic apparatus 200 as the temperature T(m1) of the virtual secondary battery.

The first apparatus control element 221 recognizes the deterioration degree D(m2) of the virtual secondary battery simulated by the simulated battery 230 (FIG. 3/STEP 218). For example, the first apparatus control element 221 may recognize the deterioration degree set through the input interface 202 of the electronic apparatus 200 as the deterioration degree D(m2) of the virtual secondary battery.

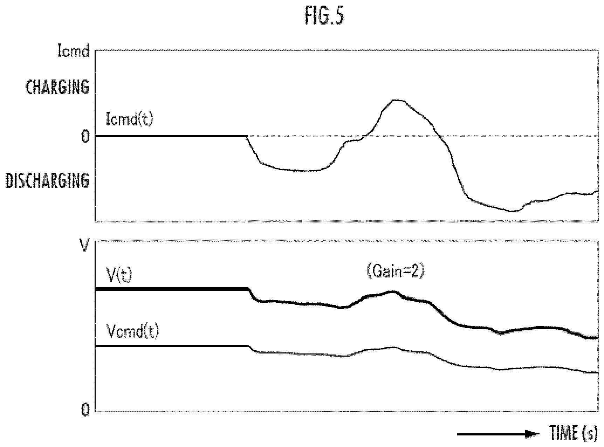

The second apparatus control element 222 recognizes the current command value Icmd(t) (FIG. 3/STEP 220). For example, the second apparatus control element 222 may recognize a current target value of the specified load 250 set according to the operation status of the electronic apparatus 200, which is measured by the sensor group 206 of the electronic apparatus 200, as the current command value Icmd(t). Further, the second apparatus control element 222 may recognize the current target value set through the input interface 202 of the electronic apparatus 200 as the current command value Icmd(t). As a result, for example, the current command value Icmd(t) that changes with time is recognized as illustrated by the solid line in the upper part of FIG. 5.

The first apparatus control element 221 transmits the identifier id(m0), the temperature T(m1), and the deterioration degree D(m2) for identifying the type of the virtual secondary battery to the simulated battery control device 100, and the second apparatus control element 222 transmits the current command value Icmd(t) to the simulated battery control device 100 (FIG. 3/STEP 222).

In the simulated battery control device 100, when the first control element 110 recognizes the identifier id(m0), the temperature T(m1), and the deterioration degree D(m2) for recognizing the type of the virtual secondary battery (FIG. 3/C11), based on the identification result, a secondary battery model is determined by a parameter P(m0,m1,m2) from among a plurality of secondary battery models registered in the database 10 (FIG. 3/STEP 110). The value of the parameter P(m0, m1, m2) that defines the transfer function H of the calculator 121 illustrated in FIG. 2 is equivalent to the value set or changed by the model parameter setting element 122 based on the deterioration degree D(n2) of the virtual secondary battery simulated by the simulated battery 230. The secondary battery model is a model that outputs the voltage value V(t) estimated or predicted to be output by the corresponding secondary battery when a current value I(t) is input. As a secondary battery model, various models can be used, such as the models described in JP-A-2008-241246, JP-A-2010-203935, and JP-A-2017-138128.

The second control element 120 inputs the current command value Icmd(t) to the selected secondary battery model, and calculates the voltage command value Vcmd(t) as the output of the secondary battery model (FIG. 3/STEP 120). As a result, for example, the voltage command value Vcmd(t) that changes as illustrated by the thin line in the lower part of FIG. 5 is calculated as the output of the secondary battery model.

Subsequently, the third control element 130 transmits the voltage command value Vcmd(t) calculated by the second control element 120 to the electronic apparatus 200 (FIG. 4/STEP 130). In response to this, when the voltage command value Vcmd(t) is recognized by the third apparatus control element 223 in the electronic apparatus 200 (FIG. 4/C21), the third apparatus control element 223 applies the voltage V(t) multiplied by the gain of the amplifier 232 in the simulated battery 230 to the specified load 250 based on the voltage command value Vcmd(t) (FIG. 4/STEP 224). As a result, for example, the voltage V(t) that changes as illustrated by the thick line in the lower part of FIG. 5 is applied to the specified load 250.

The third apparatus control element 223 recognizes an operating characteristic OC(t) of the specified load 250 when the voltage V(t) is applied (FIG. 4/STEP 226). For example, when the specified load 250 is an actuator, a time series of the displacement amount or work amount of the actuator measured by the displacement sensors or the like constituting the sensor group 206 is recognized as an operating characteristic OC(t). Further, when the specified load 250 is an arithmetic processing resource such as a CPU, a time series of the temperature of the arithmetic processing resource measured by the temperature sensor constituting the sensor group 206 may be recognized as the operating characteristic OC(t).

Next, the third apparatus control element 223 transmits the operating characteristic OC(t) of the specified load 250 to the simulated battery control device 100 (FIG. 4/STEP 228). In response to this, when the operating characteristic OC(t) of the specified load 250 is recognized by the third control element 130 in the simulated battery control device 100 (FIG. 4/C12), the third control element 130 generates operating characteristic information Info (OC(t)) representing the operating characteristic OC(t) (FIG. 4/STEP 132). For example, a graph or a diagram representing the operating characteristic OC(t) of the specified load 250, and further, the operating characteristic information Info (OC(t)) including the presence or absence of an abnormality in the operation of the specified load 250 in view of the operating characteristic OC(t) may be generated. The operating characteristic information Info (OC(t)) may be registered in the database 10 in association with the apparatus identifier for identifying the electronic apparatus 200.

Subsequently, in the electronic apparatus 200, it is determined whether or not a second specified operation is performed through the input interface 202 through the third apparatus control element 223 (FIG. 4/STEP 230). For example, an operation for switching the output interface 204 of the electronic apparatus 200 from ON to OFF, an operation for switching the output interface 204 of the electronic apparatus 200 from OFF (or sleep state) to ON (or wake state), an operation for stopping the operation of a predetermined application or load so that the arithmetic processing load such as CPU utilization and the like can be reduced to equal to or lower than a threshold, or an operation for starting a predetermined application or load corresponds to the "second specified operation".

If the determination result is negative (FIG. 4/STEP 230: NO), a series of processing is completed, and the processing after the determination processing of whether or not the electronic apparatus 200 is coupled to the charger 400 (FIG. 3/STEP210) is executed.

On the other hand, when it is determined that the second specified operation has been performed(FIG. 4/STEP 230: YES), the third apparatus control element 223 transmits an operating characteristic information request to the simulated battery control device 100 (FIG. 4/STEP 232). In response to this, when the operating characteristic information request is recognized by the third control element 130 in the simulated battery control device 100 (FIG. 4/C13), the third control element 130 transmits the operating characteristic information Info (OC(t)) to the electronic apparatus 200 (FIG. 4/STEP 134).

In response to this, when the operating characteristic information Info (OC(t)) is recognized by the third apparatus control element 223 in the electronic apparatus 200 (FIG. 4/C22), the third control element 130 outputs the operating characteristic information Info (OC(t)) through the output interface 204 (FIG. 4/STEP 234).

(Method for Establishing Secondary Battery Model)

An embodiment of a method for establishing a secondary battery model will be described. In the present embodiment, for various types of secondary battery 240 whose type is identified by the identifier ID(n0), in each of the different deterioration degrees D(n2), the parameter P(n0, n1, n2) of the secondary battery model at each of the different temperatures T(nl) is determined.

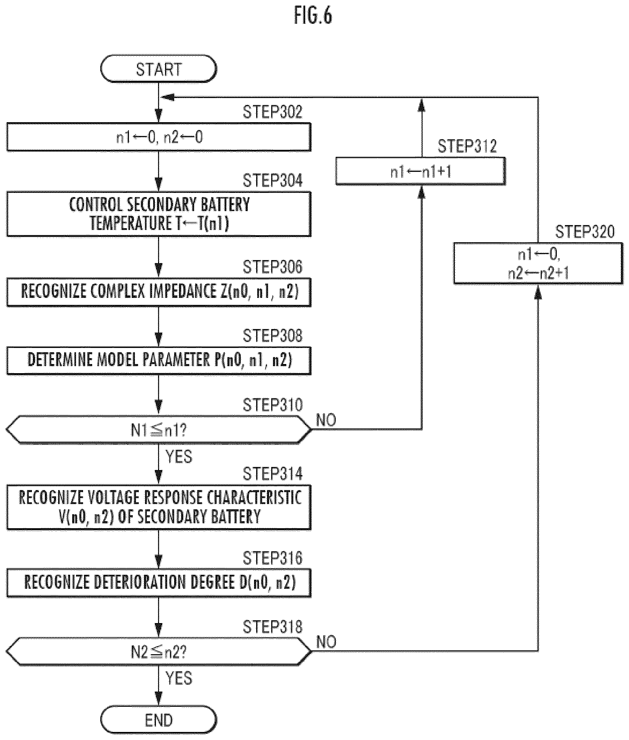

Specifically, first, in the simulated battery control device 100, each of a first index n1 and a second index n2 is set to "0" (FIG. 6/STEP 302). The first index n1 is an index indicating the height of the temperature T of the secondary battery 240. The second index n2 is an index indicating the number of evaluations or the order of the evaluation period of the deterioration degree D of the secondary battery 240.

The temperature T of the secondary battery 240 is controlled to the temperature T(nl) (FIG. 6/STEP 304). When controlling the temperature of the secondary battery 240, in addition to the heater (electric heater and the like) and cooler (cooling fan and the like) located near the secondary battery 240, a temperature sensor located near the secondary battery 240 or attached on the housing of the secondary battery 240 is used.

The first control element 110 recognizes the measurement result of a complex impedance Z(n0, n1, n2) of the secondary battery 240 (FIG. 6/STEP 306). The complex impedance Z(n0, n1, n2) of the secondary battery 240 is measured by the AC impedance method, and the measurement result is registered in the database 10 in association with the battery identifier ID (n0) for identifying the type of secondary battery 240.

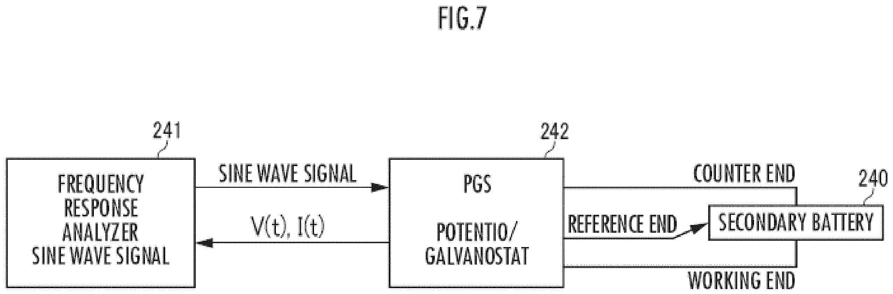

According to the AC impedance method, a combination of a frequency response analyzer (FRA) 241 and a potentio/galvanostat (PGS) 242 is used, as illustrated in FIG. 7. A sine wave signal of an arbitrary frequency is output from the oscillator constituting the FRA 241, and a current signal I(t) and a voltage signal V(t) of the secondary battery 240 corresponding to the sine wave signal are input from the PGS 242 to the FRA 241. Then, in the FRA 241 the current signal I(t) and the voltage signal V(t) are converted into data in the frequency domain by discrete Fourier frequency conversion, and the complex impedance Z(n0, n1, n2)($\omega$) at the frequency f = ($\omega/2\pi$) is measured.

For example, the complex impedance Z(n0, n1, n2) of the secondary battery 240 is measured in the state of not being mounted on the electronic apparatus 200, such as immediately before the shipment of the secondary battery 240. In addition, the complex impedance Z(n0, n1, n2) of the secondary battery 240 in the state of being mounted on the electronic apparatus 200 may be measured. In this case, the FRA 241 may be configured by the control device 210, and the sensor group 206 may be configured by the PGS. For example, the electronic apparatus 200 may be coupled to an external power supply such as a commercial power supply or the charger 400 for charging the secondary battery 240, and a sine wave signal may be output by the power supplied from an external power supply or the charger 400.

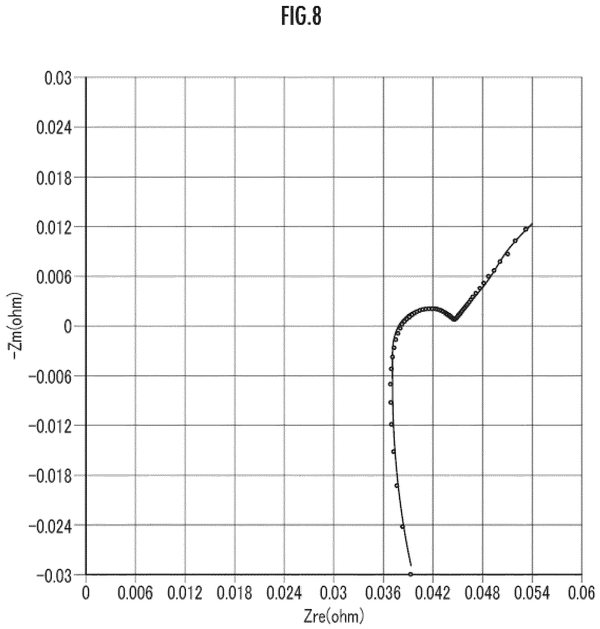

FIG. 8 illustrates an example of a Nyquist plot illustrating the actual measurement result of the complex impedance Z(n0, n1, n2) of the secondary battery 240 together with the approximate curve of the plot. The horizontal axis is a real part ReZ of the complex impedance Z, and the vertical axis is an imaginary part -ImZ of the complex impedance Z. At the region of -ImZ > 0, the larger ReZ is, the lower the frequency of the complex impedance Z is. The value of ReZ at -ImZ = 0 is equivalent to the movement resistance of the secondary battery 240 in the electrolytic solution. The radius of curvature of the substantially semicircular portion in the region of -ImZ > 0 is equivalent to the charge transfer resistance of the secondary battery 240. The radius of curvature tends to become smaller as the temperature T of the secondary battery 240 becomes higher. The influence of the Warburg impedance of the secondary battery 240 is reflected in the linear portion rising at about 45° in the low frequency region in the region of -ImZ > 0.

In the simulated battery control device 100, the value of the parameter P(n0, n1, n2) of the secondary battery model is identified by the first control element 110 based on the measurement result of the complex impedance Z of the secondary battery 240 (FIG. 6/STEP 308). The parameter P(n0, n1, n2) defines the transfer function H of the calculator 121 (see FIG. 2).

The secondary battery model is a model representing the voltage V(t) output from the secondary battery 240 when the current I(t) is input to the secondary battery 240. The secondary battery model is defined by a relational equation (01) by using the open circuit voltage OCV of the secondary battery 240 and the transfer function H(t) of the internal resistance.

$$V(t) = OCV(t) + H(t) * I(t) \dots (01)$$

Here, OCV(t) indicates that the open circuit voltage increases or decreases with charging and/or discharging of the current I(t).

The transfer function H(z) of the equivalent circuit model of the internal resistance of the secondary battery is defined by a relational equation (02). The transfer function may be coupled in series instead of coupled in parallel.

$$H(z) = H_0(z) + \sum_{i=1}^{m} Hi(z) + H_W(z) + H_L(z) \dots (02).$$

"Ho(z)", "Hi(z)", "$H_W(z)$" and "$H_L(z)$" are defined by parameters representing the characteristics of the internal resistance of the secondary battery.

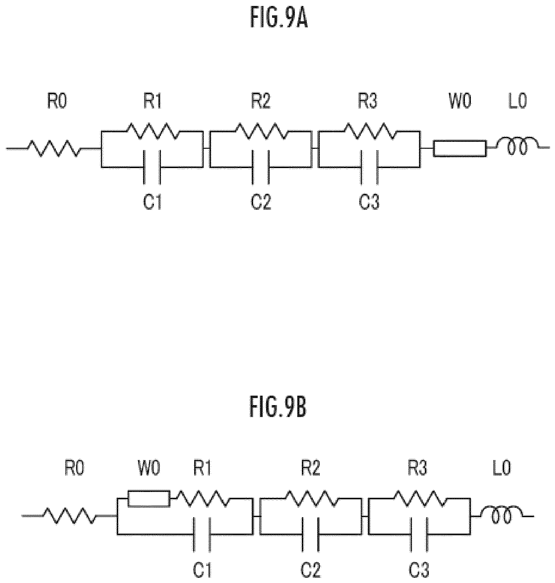

FIG. 9A illustrates an example of an equivalent circuit of the internal resistance of the secondary battery 240. In this example, the internal resistance equivalent circuit is defined by a resistor Ro equivalent to the movement resistance in the electrolytic solution, an i-th RC parallel circuit consisting of a resistor Ri equivalent to the charge transfer resistance and a capacitor Ci (i = 1, 2, ..., X), a resistor Wo equivalent to the Warburg impedance, and a series circuit of a coil L. The number of RC parallel circuits coupled in series was "3" in the embodiment illustrated in FIG. 9A, but may be smaller than 3 or larger than 3. The resistor Wo may be coupled in series with the resistor R in at least one RC parallel circuit. The capacitor C may be replaced with a constant phase element (CPE). As illustrated in FIG. 9B, a Warburg resistor W may be coupled in series with the resistor R of at least one RC parallel circuit (first RC parallel circuit in the example of FIG. 5B).

The transfer function Ho(z) of the resistor Ro is defined by a relational equation (03).

$$H_0(z) = R_0 \dots (03)$$

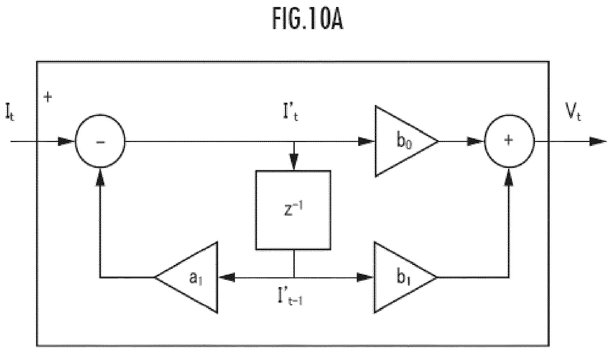

The transfer function $H_i(z)$ of the i-th RC parallel circuit is defined by the relational equation (03) as the transfer function of an infinite impulse response (IIR) system. FIG. 10A illustrates a block diagram representing the transfer function $H_i(z)$ of the i-th RC parallel circuit.

$$H_i(z) = (b_0 + b_i z^{-1})/(1 + a_i z^{-1}) \dots (03)$$

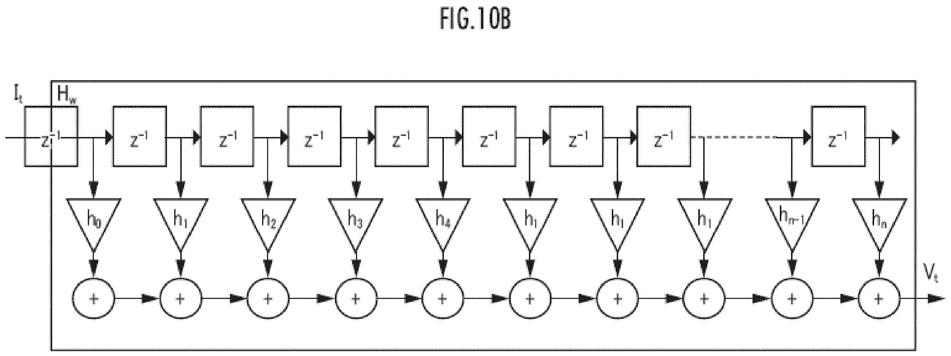

The transfer function Hw(z) of the resistor Wo equivalent to the Warburg impedance is defined by the relational equation (04) as the transfer function of a finite impulse response (FIR) system. FIG. 10B illustrates an example of a block diagram representing the transfer function Hw(z) of the resistor W0 equivalent to the Warburg impedance.

$$H_W(z) = \sum_{i=1}^{n} h_k z^{-k} \dots (04)$$

The transfer function $H_L(z)$ of the coil L is defined by the relational equation (05).

$$H_L(z) = (2L_0/T)(1 - z^{-1})/(1 + z^{-1}) \dots (05)$$

The approximate curve of the complex impedance Z of the secondary battery represented by the Nyquist plot illustrated by the solid line in FIG. 8 is obtained under the assumption that the transfer function H(z) of the equivalent circuit model of the internal resistance of the secondary battery is defined according to the relational equation (02). As a result, the value of the parameter $P(n0, n1, n2) = \{R_0, a_i, b_0, b_i, h_k, L_0, T\}$ can be obtained (see the relational equations (03) to (05)). The measured value of the open circuit voltage OCV(n0, n1, n2) identifies the value of the open circuit voltage OCV(t) output from the output device 123 in the secondary battery model (see the relational equation (01)). Then, depending on the value of the parameter, a secondary battery model is established for various types of secondary battery 240.

It is determined whether or not the first index n1 is a predetermined number N1 or more (FIG. 6/STEP 310). If the determination result is negative (FIG. 6/STEP 310: NO), the value of the first index n1 is increased by "1" (FIG. 6/STEP 312), and then the processing after the temperature control of the secondary battery 240 is repeated (FIG. 6/STEP 304 → 306 → 308 → 310).

(Second Embodiment)

(Configuration of Simulated Battery Control System)

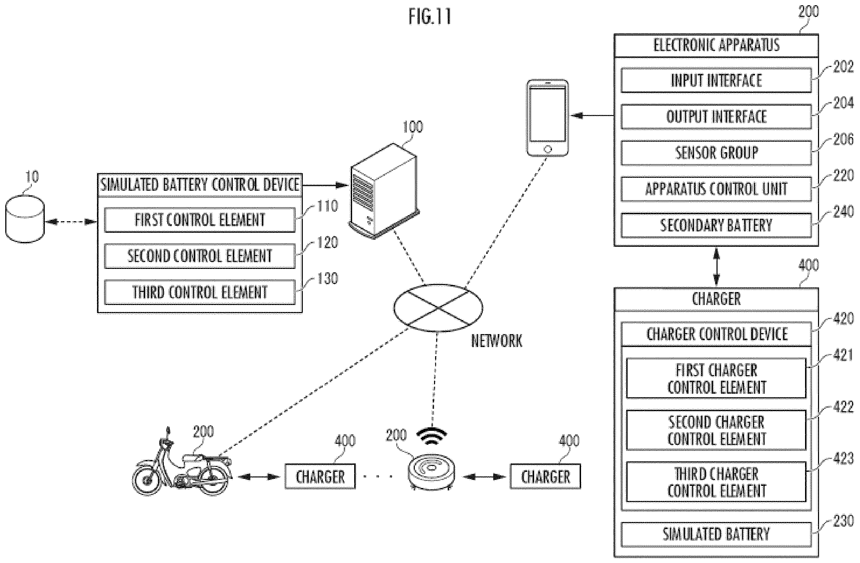

A simulated battery control system as a second embodiment of the present invention illustrated in FIG. 11 includes a simulated battery control device 100, an electronic apparatus 200, and a charger 400. The simulated battery control device 100 and charger 400 are capable of communicating via a network to each other.

The charger 400 includes a charger control device 420 and a simulated battery 230. The charger control device 420 includes a first charger control element 421, a second charger control element 422, and a third charger control element 423. Each of the first charger control element 421, the second charger control element 422, and the third charger control element 423 includes a processor (arithmetic processing unit), a memory (storage device), an I/O circuit, and the like. A memory or a storage device separate from the memory stores various data such as the simulated battery identifier ID(m0), the simulated battery temperature T(m1), the virtual deterioration degree D(m2), and the current command value Icmd(t) (see FIG. 3/STEPS 214, 216, 218, and 220). Each of the first charger control element 421, the second charger control element 422, and the third charger control element 423 performs the same functions as the first apparatus control element 221, the second apparatus control element 222, and the third apparatus control element 223 of the electronic apparatus 200.

While the charger 400 includes the simulated battery 230, the simulated battery 230 (see FIG. 1) is omitted in the electronic apparatus 200.

In addition, since the configuration is almost the same as that of the simulated battery control system (see FIG. 1) in the first embodiment, the same reference numerals are given and the description thereof will be omitted.

(Simulated Battery Control Method)

The simulated battery control method of the secondary battery 240 mounted on the electronic apparatus 200, which is executed by the simulated battery control system of the second embodiment with the above configuration, will be described. In the second embodiment, the charger 400 mutual communicates with the simulated battery control device 100 instead of the electronic apparatus 200, and the operation of the simulated battery 230 is controlled by the same procedure as in the first embodiment (see FIGS. 3 to 4).

Specifically, the determination result on whether the first specified operation is performed by the first apparatus control element 221 is transmitted wirelessly or by wire from the electronic apparatus 200 to the charger 400, and the first charger control element 421 recognizes the determination result on whether the first specified operation is performed (see FIG. 3/STEP 212).

The voltage V(t) is input to the secondary battery 240 mounted on the electronic apparatus 200 wirelessly or by wire by using the simulated battery 230 by the first charger control element 421 (see FIG. 4/STEP 224).

The first apparatus control element 221 transmits the simulated battery identifier ID(m0), the simulated battery temperature T(m1), and the virtual deterioration degree D(m2) to the charger 400 wirelessly or by wire, and the first charger control element 421 recognizes the simulated battery identifier ID(m0), the simulated battery temperature T(m1), and the virtual deterioration degree D(m2) (see FIGS. 3/STEPS 214, 216, and 218). Subsequently, the simulated battery identifier ID(m0), the simulated battery temperature T(m1), and the virtual deterioration degree D(m2) are transmitted from the charger 400 to the simulated battery control device 100 by the first charger control element 421 (see FIG. 3/STEP 222).

The second apparatus control element 222 transmits the current command value Icmd(t) to the charger 400 wirelessly or by wire, and the second charger control element 422 recognizes the current command value Icmd(t) (see FIG. 3/STEP 220). Subsequently, the second charger control element 422 transmits the current command value Icmd(t)

EP 4 053 962 A1

from the charger 400 to the simulated battery control device 100 (see FIG. 3/STEP 222).

The third charger control element 423 applies the voltage V(t) multiplied by the gain of the amplifier 232 in the simulated battery 230 to the specified load 250 of the electronic apparatus 200 coupled to the charger 400 based on the voltage command value Vcmd(t) (see FIG. 4/STEP 224). The third charger control element 423 recognizes the operating characteristic OC(t) of the specified load 250 when the voltage V(t) is applied based on the communication with the electronic apparatus 200 (see FIG. 4/STEP 226).

Next, the third charger control element 423 transmits the operating characteristic OC(t) of the specified load 250 to the simulated battery control device 100 (see FIG. 4/STEP 228).

Subsequently, the third apparatus control element 223 determines whether the second specified operation is performed through the input interface 202 (see FIG. 4/STEP 230). Then, when it is determined that the second specified operation has been performed (FIG. 4/STEP 230: YES), the third charger control element 423 transmits an operating characteristic information request to the simulated battery control device 100 (see FIG. 4/STEP 232).

Further, the operating characteristic information Info(OC(t)) is received by the third charger control element 423 and transmitted to the electronic apparatus 200 wirelessly or by wire, and the operating characteristic information Info(OC(t)) is output through the output interface 204 (see FIG. 4/C22 → STEP 234).

(Other Embodiments of Present Invention)

The function of the apparatus control unit 220 in the first embodiment may be shared by the electronic apparatus 200 and the charger control device 420 in the second embodiment.

For example, in the second embodiment, the simulated battery control information Info(D) may be received from the third apparatus control element 223 and output to the display device constituting the output interface 204 according to the determination result on whether the second specified operation is performed (see FIG. 3/STEP 220 → STEP 222: YES → STEP 224). In this case, the third charger control element 423 may be omitted.

Further, in the second embodiment, the battery identifier ID may be transmitted to the simulated battery control device 100 by the second apparatus control element 222 (see FIG. 3/STEP 220). In this case, the second charger control element 422 may be omitted.

A secondary battery model is selected based on the temperature T of the secondary battery 240 or the electronic apparatus 200 during the measurement of the voltage response characteristic V(T), and the performance of the secondary battery 240 is evaluated, but as another embodiment, a secondary battery model may be selected based on the battery identifier ID representing the type of secondary battery 240 and the performance of the secondary battery 240 may be evaluated without considering the temperature T of the secondary battery 240 during the measurement of the voltage response characteristic V(T).

(Effect of Invention)

According to the simulated battery control device 100 according to the present invention and the simulated battery control method executed by the simulated battery control device 100, based on the communication between the electronic apparatus 200 and/or the charger 400 coupled to the electronic apparatus 200, and the simulated battery control device 100, the performance of the secondary battery 240 mounted in the electronic apparatus 200 is evaluated by the simulated battery control device 100. Then, the battery performance information Info(D) corresponding to the evaluation result is output to the output interface 204 of the electronic apparatus 200. Therefore, a user does not need to bring the electronic apparatus 200 or the secondary battery 240 to a specialized institution or the like, and the performance evaluation result of the secondary battery 240 can be grasped, and therefore the convenience for the user of the electronic apparatus 200 is improved.

(Deterioration Degree Determination)

As the virtual deterioration degree D(m2) of the simulated battery 230, the estimation result of the deterioration degree of the secondary battery 240 may be recognized (see FIG. 3/STEP 218).

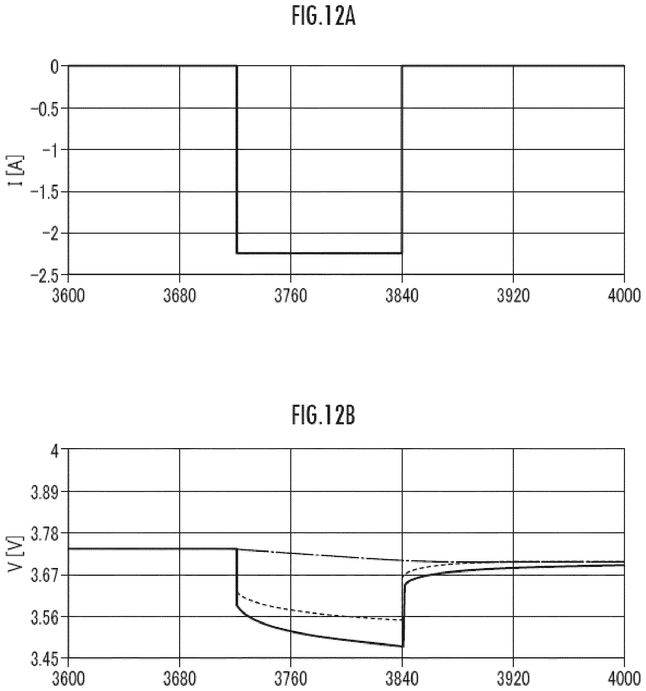

For example, the first apparatus control element 221 recognizes the measurement result of a voltage response characteristic V(n0, n2)(t) (to V(n0, n2)(z)) according to an impulse current I(t) of the secondary battery 240. At the time of the measurement, the impulse current I(t) (to I(z)) is input to the secondary battery 240 by the first apparatus control element 221. For example, the impulse current I(t) as illustrated in FIG. 12A is input to the secondary battery 240. By driving a pulse current generator, the impulse current I(t) generated in the pulse current generator is input to the secondary battery 240. When the secondary battery 240 is mounted on the electronic apparatus 200, the pulse current generator may be mounted on the electronic apparatus 200 and a specified device mounted on the electronic apparatus 200 may be driven by the supply power from an external power supply or auxiliary power supply mounted on the electronic

11

apparatus 200 to generate an impulse current.

Then, the voltage response characteristic V(n0, n2)(t) of the secondary battery 240 is measured by the first apparatus control element 221 based on the output signal of the voltage sensor constituting the sensor group 206. Thereby, for example, the voltage response characteristic V(n0, n2)(t) of the secondary battery 240 that changes as illustrated by the broken line in FIG. 12B is measured. FIG. 12B illustrates the measurement result of a voltage response characteristic V(n0,0)(t) of the secondary battery 240 when the second index n2 is 0 the solid line.

Subsequently, the first apparatus control element 221 evaluates the deterioration degree D(n0, n2) of the secondary battery 240 whose type is identified by the battery identifier ID (n0) based on the comparison result of the voltage response characteristics V(n0,n2)(t) and V(n0,0)(t) of the secondary battery 240. For example, a similarity x of the curve representing each of the voltage response characteristics V(n0, n2)(t) and V(n0,0)(t) of the secondary battery 240 is calculated. Then, the deterioration degree D(n0, n2) = f(x) of the secondary battery 240 is calculated according to a decreasing function f having the similarity x as a main variable.

It is determined whether or not the second index n2 is a predetermined number N2 or more. If the determination result is negative, the value of the first index n1 is reset to "0" and the value of the second index n2 is increased by "1". Then, the processing after the temperature control of the secondary battery 240 is repeated.

In the above embodiment, the value of the parameter P(n0, n1, n2) of the secondary battery model is determined individually according to the difference in the deterioration degree D(n2) of the secondary battery 240 whose type identified by the battery identifier ID(n0) (FIG. 6/STEPS 308, 314, and 316), but as another embodiment, the value of the parameter P(n0, n1) of the secondary battery model may be determined without considering the difference in the deterioration degree D(n2) of the secondary battery 240.

In the above embodiment, the value of the parameter P(n0,n1,n2) of the secondary battery model is determined individually according to the difference in the temperature T(nl) of the secondary battery 240 whose type is identified by the identifier ID(n0) (FIG. 6/STEPS 304, 314, and 316), but as another embodiment, the value of the parameter P(n0, n2) of the secondary battery model may be determined without considering the difference in the temperature T(nl) of the secondary battery 240.

(Effect of Invention)

According to the simulated battery control device 100 according to the present invention and the simulated battery control method executed by the simulated battery control device 100, based on the mutual communication between the electronic apparatus 200 and/or the charger 400 coupled to the electronic apparatus 200, and the simulated battery control device 100, the operation of the simulated battery 230 mounted on the electronic apparatus 200 is controlled, and the voltage V(t) corresponding to the current command value Icmd(t) is applied to the specified load 250. Then, the operating characteristic information Info (OC(t)) corresponding to the operating characteristic OC(t) of the specified load 250 corresponding to the applied voltage V(t) is output to the output interface 204 of the electronic apparatus 200. Therefore, the user does not need to bring the electronic apparatus 200 to a specialized institution or the like, and the operating characteristics OC(t) of the specified load 250 can be grasped when voltage V(t) corresponding to the current command value Icmd(t) is applied to the specified load 250 of the electronic apparatus 200, and therefore the convenience of the user of the electronic apparatus 200 can be improved.

Further, for the secondary battery 240 whose type is identified by the battery identifier ID(n0), in each of the different deterioration degrees D(n2), the parameter P(n0, n1, n2) of the secondary battery model at each of the different temperatures T(nl) is determined. Based on the measurement result of the complex impedance Z of the secondary battery 240, the value of the parameter P(n0, n1, n2) of the secondary battery model is identified (see FIG. 6/STEP 304 → 306 → 308, FIGS. 7 to 9, and FIGS. 10A and 10B). In the secondary battery model, the impedance of the internal resistance of the secondary battery 240 is expressed by a transfer function representing each of the IIR system and the FIR system (see the relational equations (03) and (04), FIGS. 7 to 9, and FIGS. 10A and 10B).

Further, a secondary battery model having a parameter P(m,m1,m2) is selected based on the identifier ID(m), temperature T(m1), and deterioration degree D(m2) of the virtual secondary battery simulated by the simulated battery 230 (see FIG. 2, FIG. 4/STEP 214 → 216 → 218 → 110). Then, the voltage command value Vcmd(t), which is the output when the current command value Icmd(t) is input to the secondary battery model, is calculated, and the corresponding voltage V(t) is applied to the specified load 250 of the electronic apparatus 200 by the simulated battery 230 (see FIG. 3/STEP 120, FIG. 4/STEP 130 → 224, and FIG. 5). As a result, the reproduction accuracy of the characteristics of the secondary battery 240 by the simulated battery 230 can be improved under various conditions.

Description of Reference Numerals

| 10 | database |
|---|---|
| 100 | simulated battery control device |
| 110 | first control element |
| 120 | second control element |
| 130 | third control element |
| 200 | electronic apparatus |
| 202 | input interface |
| 204 | output interface |
| 206 | sensor group |
| 220 | apparatus control unit |
| 221 | first apparatus control element |
| 222 | second apparatus control element |
| 223 | third apparatus control element |
| 230 | simulated battery |
| 240 | secondary battery |
| 250 | specified load |
| 400 | charger |
| 420 | charger control device |
| 421 | first charger control element |
| 422 | second charger control element |
| 423 | third charger control element. |

**Claims**

1. A simulated battery control device comprising:

   a first control element configured to identify a value of a parameter of a secondary battery model representing current dependence of an output voltage of a secondary battery mounted or to be mounted on an electronic apparatus as a power supply, based on communication with the electronic apparatus;
   a second control element configured to recognize a time series of command current values based on the communication with the electronic apparatus and to calculate a model output voltage as a change mode of a voltage output from the secondary battery model when the time series of the command current values is input to the secondary battery model of which the value of the parameter is recognized by the first control element; and
   a third control element configured to apply the model output voltage calculated by the second control element to a simulated battery mounted on the electronic apparatus or a power supply device for a specified load of the electronic apparatus, based on communication with the electronic apparatus or the power supply device as a charging power supply of the secondary battery.

2. The simulated battery control device according to claim 1, wherein
   the first control element recognizes a deterioration degree of the secondary battery based on the communication with the electronic apparatus, and identifies a value corresponding to a difference in the deterioration degree as the value of the parameter of the secondary battery model.

3. The simulated battery control device according to claim 1 or 2, wherein
   the first control element recognizes a measurement result of a temperature of the electronic apparatus or the simulated battery based on the communication with the electronic apparatus or the power supply device, and identifies a value corresponding to a difference in the measurement result of the temperature as the value of the parameter of the secondary battery model.

4. The simulated battery control device according to any one of claims 1 to 3, wherein
   the first control element identifies the value of the parameter of the secondary battery model, and the second control element calculates the model output voltage provided that a first specified operation is performed through an input interface of the electronic apparatus.

5. The simulated battery control device according to claim 4,
   the first control element identifies the value of the parameter of the secondary battery model, and the second control element calculates the model output voltage provided that a power cut-off operation is performed through the input interface in the electronic apparatus as the first specified operation.

6. The simulated battery control device according to any one of claims 1 to 5, wherein
the first control element identifies the value of the parameter of the secondary battery model, and the second control element calculates the model output voltage provided that the electronic apparatus is coupled to a charger.

7. The simulated battery control device according to any one of claims 1 to 6, wherein
the third control element outputs information about operating characteristics of the specified load, when the model output voltage calculated by the second control element is applied to the simulated battery for the specified load of the electronic apparatus, to an output interface of the electronic apparatus.

8. The simulated battery control device according to claim 7, wherein
the third control element outputs the information about the operating characteristics of the specified load to the output interface based on the communication with the electronic apparatus provided that a second specified operation is performed through an input interface of the electronic apparatus.

9. The simulated battery control device according to claim 8, wherein
the third control element outputs the information about the operating characteristics of the specified load to the output interface based on the communication with the electronic apparatus provided that a wake operation of a sleep state of the output interface is performed through the input interface of the electronic apparatus as the second specified operation.

10. The simulated battery control device according to any one of claims 1 to 9, wherein
the simulated battery is configured to be detachably mounted on the power supply device and to be mounted on the electronic apparatus as a replacement battery of the secondary battery.

11. An electronic apparatus on which a secondary battery is mounted as a power supply, the device comprising:

    a simulated battery;
    a specified load;
    a first apparatus control element configured to cause a first control element constituting a simulated battery control device to identify a value of a parameter of a secondary battery model representing current dependence of an output voltage of the secondary battery based on communication with the simulated battery control device;
    a second apparatus control element configured to cause a second control element constituting the simulated battery control device to recognize a time series of command current values based on the communication with the simulated battery control device and to calculate a model output voltage as a change mode of a voltage output from the secondary battery model when the time series of the command current values is input to the secondary battery model of which the value of the parameter is recognized by the first control element; and
    a third apparatus control element configured to apply the model output voltage calculated by the second control element to the specified load from the simulated battery based on the communication with the simulated battery control device.

12. A charger that is coupled to an electronic apparatus on which a secondary battery is mounted as a power supply, the charger comprising:

    a simulated battery;
    a first charger control element configured to cause a first control element constituting a simulated battery control device to identify a value of a parameter of a secondary battery model representing current dependence of an output voltage of the secondary battery based on communication with the simulated battery control device;
    a second charger control element configured to cause a second control element constituting the simulated battery control device to recognize a time series of command current values based on the communication with the simulated battery control device and to calculate a model output voltage as a change mode of a voltage output from the secondary battery model when the time series of the command current values is input to the secondary battery model of which the value of the parameter is recognized by the first control element; and
    a third charger control element configured to apply the model output voltage calculated by the second control element to a specified load of the electronic apparatus from the simulated battery based on the communication with the simulated battery control device.

13. A simulated battery control method comprising:

a first control step of identifying a value of a parameter of a secondary battery model representing current dependence of an output voltage of a secondary battery mounted or to be mounted on an electronic apparatus as a power supply, based on communication with the electronic apparatus;

a second control step of recognizing a time series of command current values based on the communication with the electronic apparatus and calculating a model output voltage as a change mode of a voltage output from the secondary battery model when the time series of the command current values is input to the secondary battery model of which the value of the parameter is recognized in the first control step; and

a third control step of applying the model output voltage calculated in the second control step to a simulated battery mounted on the electronic apparatus or a power supply device for a specified load of the electronic apparatus, based on communication with the electronic apparatus or the power supply device as a charging power supply of the secondary battery.

FIG.1

EP 4 053 962 A1

FIG.2

## FIG.3

SIMULATED BATTERY CONTROL DEVICE 100        ELECTRONIC APPARATUS 200

```
        ( START )                              ( START )
            │                                      │          STEP210
            ▼                                      ▼                      NO
         ( C11 )◄- - - - - - - - - - -<  COUPLED TO CHARGER  >──────┐
            │                    │           │ YES    STEP212        │
            ▼         STEP110    │           ▼                  NO   │
┌──────────────────────────┐    │    <  IS FIRST SPECIFIED  >───────┤
│ SPECIFY SECONDARY BATTERY│    │    < OPERATION PERFORMED? >        │
│  MODEL HAVING PARAMETER  │    │           │ YES    STEP214         │
│     P(m0, m1, m2)        │    │           ▼                        │
└──────────────────────────┘    │   ┌──────────────────────┐        │
            │         STEP120    │   │   RECOGNIZE SIMULATED│        │
            ▼                    │   │ BATTERY IDENTIFIER ID(m0)│    │
┌──────────────────────────┐    │   └──────────────────────┘        │
│  RECOGNIZE VOLTAGE       │    │           │         STEP216        │
│  COMMAND VALUE Vcmd(t) OF │    │          ▼                        │
│ SECONDARY BATTERY MODEL  │    │   ┌──────────────────────┐        │
└──────────────────────────┘    │   │   RECOGNIZE SIMULATED│        │
            │                    │   │ BATTERY TEMPERATURE T(m1)│    │
            ▼                    │   └──────────────────────┘        │
          /10\                   │           │         STEP218        │
          ‾‾‾‾                   │           ▼                        │
                                 │   ┌──────────────────────┐        │
                                 │   │ RECOGNIZE VIRTUAL    │        │
                                 │   │ DETERIORATION DEGREE D(m2)│   │
                                 │   └──────────────────────┘        │
                                 │           │         STEP220        │
                                 │           ▼                        │
                                 │   ┌──────────────────────┐        │
                                 │   │ RECOGNIZE CURRENT    │        │
                                 │   │ COMMAND VALUE Icmd(t)│        │
                                 │   └──────────────────────┘        │
                                 │           │         STEP222        │
                                 │           ▼                        │
                                 │   ┌──────────────────────┐        │
                                 └ - │      TRANSMIT        │        │
                                     │ ID(m0) + T(m1) +     │        │
                                     │  D(m2) + Icmd(t)     │        │
                                     └──────────────────────┘        │
                                             │◄───────────────────────┘
                                             ▼
                                           /20\
                                           ‾‾‾‾
```

18

## FIG.4

SIMULATED BATTERY CONTROL DEVICE 100      ELECTRONIC APPARATUS 200

```
        ┌─10─┐                                    ┌─20─┐
          │                                         │
          ▼                 STEP130                 ▼
  ┌──────────────────────┐                      ┌──────┐
  │   TRANSMIT VOLTAGE    │----------------------▶│ C21  │
  │ COMMAND VALUE Vcmd(t) │                      └──────┘
  └──────────────────────┘                         │         STEP224
          │                                         ▼
          │                            ┌─────────────────────────────┐
          │                            │     APPLY V(t) TO SPECIFIED   │
          │                            │        LOAD BY OPERATION      │
          │                            │ CONTROL OF SIMULATED BATTERY  │
          │                            └─────────────────────────────┘
          │                                         │         STEP226
          │                                         ▼
          │                            ┌─────────────────────────────┐
          │                            │ RECOGNIZE OPERATING CHARACTERISTIC│
          │                            │    OC(t) OF SPECIFIED LOAD    │
          │                            └─────────────────────────────┘
          │                                         │         STEP228
          ▼                                         ▼
      ┌──────┐                         ┌─────────────────────────────┐
      │ C12  │◀------------------------│        TRANSMIT OC(t)         │
      └──────┘                         └─────────────────────────────┘
          │         STEP132                         │         STEP230
          ▼                                         ▼
  ┌──────────────────────────┐         ┌─────────────────────────────┐  NO
  │ GENERATE OPERATING CHARACTERISTIC│  ◇   IS SECOND SPECIFIED OPERATION  ◇─────
  │   INFORMATION Info(OC(t))  │       ◇        PERFORMED?          ◇
  └──────────────────────────┘         └─────────────────────────────┘     │
          │                                         │ YES     STEP232       │
          ▼                                         ▼                       │
      ┌──────┐                         ┌─────────────────────────────┐      │
      │ C13  │◀------------------------│ TRANSMIT OPERATING CHARACTERISTIC│   │
      └──────┘                         │    INFORMATION REQUEST       │      │
          │         STEP134            └─────────────────────────────┘      │
          ▼                                         │                       │
  ┌──────────────────────────┐                   ┌──────┐                   │
  │ TRANSMIT OPERATING CHARACTERISTIC│            │ C22  │                   │
  │   INFORMATION Info(OC(t))  │                  └──────┘                   │
  └──────────────────────────┘                      │         STEP234       │
          │                                         ▼                       │
     ┌─────────┐                       ┌─────────────────────────────┐      │
     │   END   │                       │  OUTPUT OPERATING CHARACTERISTIC│    │
     └─────────┘                       │   INFORMATION Info(OC(t))    │      │
                                       └─────────────────────────────┘      │
                                                  │◀──────────────────────┘
                                                  ▼
                                             ┌─────────┐
                                             │   END   │
                                             └─────────┘
```

## FIG.5

## FIG.6

START

STEP302
$n1 \leftarrow 0, n2 \leftarrow 0$

STEP304
CONTROL SECONDARY BATTERY
TEMPERATURE $T \leftarrow T(n1)$

STEP306
RECOGNIZE COMPLEX IMPEDANCE $Z(n0, n1, n2)$

STEP308
DETERMINE MODEL PARAMETER $P(n0, n1, n2)$

STEP310
$N1 \leqq n1?$ — NO

STEP312
$n1 \leftarrow n1+1$

YES

STEP314
RECOGNIZE VOLTAGE RESPONSE CHARACTERISTIC
$V(n0, n2)$ OF SECONDARY BATTERY

STEP320
$n1 \leftarrow 0,$
$n2 \leftarrow n2+1$

STEP316
RECOGNIZE DETERIORATION DEGREE $D(n0, n2)$

STEP318
$N2 \leqq n2?$ — NO

YES

END

FIG.7

FREQUENCY RESPONSE ANALYZER
SINE WAVE SIGNAL

241

SINE WAVE SIGNAL

V(t), I(t)

PGS

POTENTIO/ GALVANOSTAT

242

COUNTER END

REFERENCE END

WORKING END

SECONDARY BATTERY

240

FIG.8

FIG.9A

R0    R1    R2    R3    W0    L0

C1    C2    C3

FIG.9B

R0    W0    R1    R2    R3    L0

C1    C2    C3

## FIG.10A

FIG.10B

EP 4 053 962 A1

## FIG.11

SIMULATED BATTERY CONTROL DEVICE

FIRST CONTROL ELEMENT — 110

SECOND CONTROL ELEMENT — 120

THIRD CONTROL ELEMENT — 130

100

NETWORK

200

CHARGER — 400

200

200

CHARGER — 400

ELECTRONIC APPARATUS — 200

INPUT INTERFACE — 202

OUTPUT INTERFACE — 204

SENSOR GROUP — 206

APPARATUS CONTROL UNIT — 220

SECONDARY BATTERY — 240

CHARGER — 400

CHARGER CONTROL DEVICE — 420

FIRST CHARGER CONTROL ELEMENT — 421

SECOND CHARGER CONTROL ELEMENT — 422

THIRD CHARGER CONTROL ELEMENT — 423

SIMULATED BATTERY — 230

EP 4 053 962 A1

## FIG.12A

## FIG.12B

**INTERNATIONAL SEARCH REPORT**

| International application No. |
| --- |
| PCT/JP2021/000133 |

**A. CLASSIFICATION OF SUBJECT MATTER**
H01M 10/42(2006.01)i; H01M 10/48(2006.01)i; H02J 7/00(2006.01)i; G01R 31/367(2019.01)i; G01R 31/389(2019.01) i; G01R 31/392(2019.01)i
FI:     G01R31/367; H01M10/48 P; H01M10/48 301; H01M10/42 P; G01R31/389; G01R31/392; H02J7/00 Q

According to International Patent Classification (IPC) or to both national classification and IPC

**B. FIELDS SEARCHED**

Minimum documentation searched (classification system followed by classification symbols)
H01M10/42; H01M10/48; H02J7/00; G01R31/367; G01R31/389; G01R31/392

Documentation searched other than minimum documentation to the extent that such documents are included in the fields searched
Published examined utility model applications of Japan         1922-1996
Published unexamined utility model applications of Japan       1971-2021
Registered utility model specifications of Japan               1996-2021
Published registered utility model applications of Japan       1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | WO 2011/118080 A1 (FURUKAWA ELECTRIC CO., LTD.) 29 September 2011 (2011-09-29) entire text, all drawings | 1-13 |
| A | JP 2008-76204 A (YOKOGAWA ELECTRIC CORP.) 03 April 2008 (2008-04-03) entire text, all drawings | 1-13 |
| A | JP 2011-158354 A (SINFONIA TECHNOLOGY CO., LTD.) 18 August 2011 (2011-08-18) entire text, all drawings | 1-13 |
| A | JP 2011-38928 A (YOKOGAWA ELECTRIC CORP.) 24 February 2011 (2011-02-24) entire text, all drawings | 1-13 |

☒ Further documents are listed in the continuation of Box C.      ☒ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 11 March 2021 (11.03.2021) | 23 March 2021 (23.03.2021) |

| Name and mailing address of the ISA/ | Authorized officer |
| --- | --- |
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**

International application No.

PCT/JP2021/000133

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2010-267570 A (YOKOGAWA ELECTRIC CORP.) 25 November 2010 (2010-11-25) entire text, all drawings | 1-13 |
| A | JP 2019-100897 A (HITACHI CHEMICAL CO., LTD.) 24 June 2019 (2019-06-24) entire text, all drawings | 1-13 |
| A | US 2018/0348307 A1 (TOTAL S.A.) 06 December 2018 (2018-12-06) entire text, all drawings | 1-13 |
| A | US 2006/0273800 A1 (HORNING, Randall F.) 07 December 2006 (2006-12-07) entire text, all drawings | 1-13 |

Form PCT/ISA/210 (continuation of second sheet) (January 2015)

**INTERNATIONAL SEARCH REPORT**
Information on patent family members

International application No.

PCT/JP2021/000133

| Patent Documents referred in the Report | Publication Date | Patent Family | Publication Date |
|---|---|---|---|
| WO 2011/118080 A1 | 29 Sep. 2011 | US 2013/0110429 A1 entire text, all drawings JP 2011-196906 A JP 4689755 B1 EP 2551687 A1 | |
| JP 2008-76204 A | 03 Apr. 2008 | US 2008/0294380 A1 entire text, all drawings DE 102007044890 A1 | |
| JP 2011-158354 A | 18 Aug. 2011 | (Family: none) | |
| JP 2011-38928 A | 24 Feb. 2011 | (Family: none) | |
| JP 2010-267570 A | 25 Nov. 2010 | (Family: none) | |
| JP 2019-100897 A | 24 Jun. 2019 | (Family: none) | |
| US 2018/0348307 A1 | 06 Dec. 2018 | (Family: none) | |
| US 2006/0273800 A1 | 07 Dec. 2006 | (Family: none) | |

Form PCT/ISA/210 (patent family annex) (January 2015)

31

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5924617 B
- JP 2008241246 A
- JP 2010203935 A
- JP 2017138128 A